# EUROPEAN PATENT SPECIFICATION

(11) **EP 3 391 546 B1**
(45) Date of publication and mention of the grant of the patent: **31.07.2024**
(21) Application number: 16701570.0
(22) Date of filing: 07.01.2016
(51) Int. Cl.: H04B 1/04, H04L 27/26

(54) **CONSTANT AMPLITUDE INTERPOLATION OF ZADOFF-CHU SEQUENCES**
INTERPOLATION MIT KONSTANTER AMPLITUDE VON ZADOFF-CHU-SEQUENZEN
INTERPOLATION À AMPLITUDE CONSTANTE DE SÉQUENCES DE ZADOFF-CHU

(43) Date of publication of application: 24.10.2018
(73) Proprietor: Huawei Technologies Co., Ltd., Longgang District Shenzhen, Guangdong 518129 (CN)
(72) Inventor: POPESCU, Andrei, 80992 Munich (DE); YOUNG, Robert William, 80992 Munich (DE)
(74) Representative: Gill Jennings & Every LLP
(86) International application number: PCT/EP2016/050227
(87) International publication number: WO 2017/118486

(56) References cited:
- US-B1- 6 744 807

## Description

### BACKGROUND

The present invention, in some embodiments thereof, relates to reducing out-of-band emissions for a radio frequency (RF) signal and, more specifically, but not exclusively, to reducing out-of-band emissions for the RF signal by interpolating Zadoff-Chu (ZC) sequences (from which the RF signal is derived) in a phase domain while maintaining a constant amplitude of the RF signal.

The advancement of cellular communication and in particular long term evolution (LTE) for connectivity of a plurality of user equipment (UE) units such as, for example, products, devices, platforms and/or systems presents new challenges for implementation and/or construction of the UEs and specifically for low-end UEs. The low-end UEs, for example, internet of things (IoT) UEs and/or other low-end UEs are rapidly increasing in numbers. The low-end UEs are characterized with one or more low-end aspects, for example, low power, low cost, and/or low throughput which may encourage and even force using low-end hardware, for example, low-end RF transmitters and/or low-end power amplifiers. Such low-end hardware may require adapting to new methods and/or innovations to allow communication over the cellular networks while maintaining RF signal integrity and a high quality of service, for example, high coverage, low error rate and/or timing estimation accuracy, for example, time of arrival (TOA) accuracy. Several approaches are currently being adopted and/or employed for the low-end UEs, however most of these approaches may increase complexity in one or more elements of the cellular communication chain, for example, a base-station, infrastructure and/or a UE. LTE signals employ ZC sequences which present good autocorrelation characteristics making the ZC sequences highly suitable for code-division multiplexing employed by the LTE signals where signals orthogonality is essential. Specifically, the ZC sequences allow multiple LTE UEs to share a frequency band and simultaneously transmit random access channel (RACH) signals without the RACH signals interfering each other. The RACH signals may be differentiated from each other by constructing the RACH signals using different ZC root sequences and/or applying different cyclic shifts to common ZC root sequences.

US 6744807 B1 discloses an n-dimensional direct sequence spread spectrum modulator which comprises a spreading sequence generator for generating a set of n/2 substantially mutually orthogonal spreading sequences. The spreading sequences each comprise combinations of the real and imaginary parts of complex sequences.

### SUMMARY

An object of the present invention is to reduce out-band-emissions for a radio frequency (RF) signal.

The object is achieved by the subject matter of the independent claims. The dependent claims provide further implementation forms thereof.

According to an aspect of some embodiments of the present invention there is provided an apparatus for reducing out-of-band emissions of a radio frequency (RF) signal, as set out in claim 1.

Optionally, a frequency spectrum of the at least one interpolated ZC sequence is limited to avoid further narrow-band filtering prior to the transmission of the RF signal.

Optionally, the at least one interpolated ZC sequence is created to transmit at least one random access channel (RACH) sequence.

The LPF comprises a modified Gaussian filter formed by convolving a Gaussian filter with a rectangular pulse.

Optionally, the LPF includes at least two coefficients to adapt at least one characteristic of the LPF for adjusting a limit of a bandwidth of the interpolated ZC sequence with respect to a timing accuracy of the RF signal.

The interpolation is performed in a phase domain to maintain a constant amplitude level of the RF signal.

The interpolation is performed in a phase domain to maintain an autocorrelation characteristic for each sample of the interpolated ZC sequence to be substantially similar to the autocorrelation characteristic of a respective sample of the at least one ZC sequence.

The interpolation is performed in a phase domain to maintain a cross-correlation characteristic of each sample of the at least one interpolated ZC sequence with respect to other samples of the at least one interpolated ZC sequences to be substantially similar to the cross-correlation characteristic of a respective sample of the at least one ZC sequence.

According to an aspect of some embodiments of the present invention there is provided a method for reducing out-of-band emissions of an RF signal, as set out in claim 4.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. In case of conflict, the patent specification, including definitions, will control. In addition, the materials, methods, and examples are illustrative only and are not intended to be necessarily limiting.

### BRIEF DESCRIPTION OF THE SEVERAL VIEWS OF THE DRAWINGS

Some embodiments of the invention are herein described, by way of example only, with reference to the accompanying drawings. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced.

In the drawings:
FIG. 1 is a schematic illustration of an exemplary apparatus for reducing out-of-band emissions for an RF signal, according to some embodiments of the present invention;
FIG. 2 is a flowchart of an exemplary process of reducing out-of-band emissions for an RF signal, according to some embodiments of the present invention;
FIG. 3 is a schematic illustration of an exemplary apparatus implementation for reducing out-of-band emissions for a RACH preamble signal, according to some embodiments of the present invention;
FIG. 4 is a schematic illustration of an exemplary modified Gaussian filter used for interpolating ZC sequences, according to some embodiments of the present invention;
FIG. 5 is a schematic illustration of a spectral view presenting an exemplary set of interpolated ZC sequences with respect to a global system for mobile communications (GSM) spectral mask, according to some embodiment of the present invention;
FIG. 6 is a schematic illustration of correlation characteristics graphs of exemplary ZC sequences and interpolated ZC sequences, according to some embodiment of the present invention;
FIG. 7 is a schematic illustration of an autocorrelation peak graph of exemplary ZC sequences and interpolated ZC sequences, according to some embodiment of the present invention;
FIG. 8 is a schematic illustration of missed detection probability graph of an exemplary interpolated RACH preamble signal and an exemplary original RACH preamble signal, according to some embodiment of the present invention;
FIG. 9 is a schematic illustration of timing estimation error probability graph of exemplary interpolated RACH preamble signal and an exemplary original RACH preamble signal, according to some embodiment of the present invention;
FIG. 10 is a schematic illustration of missed detection probability graph of an exemplary interpolated RACH preamble signal with repetitions, according to some embodiment of the present invention; and
FIG. 11 is a schematic illustration of timing error probability graph of an exemplary interpolated RACH preamble signal with repetitions, according to some embodiment of the present invention.

### DETAILED DESCRIPTION

The present invention, in some embodiments thereof, relates to reducing out-of-band emissions for an RF signal and, more specifically, but not exclusively, to reducing out-of-band emissions for the RF signal by interpolating ZC sequences (which constitute the RF signal) in a phase domain while maintaining a constant amplitude of the RF signal.

The present invention presents apparatus, systems and methods for interpolating the ZC sequence(s) from which the RF signal, in particular an LTE signal is derived in order to reduce the out-of-band emissions and/or spectral side-lobes of the RF signal. Interpolating the ZC sequences is done in the phase domain for limiting the phase modulation spectrum and allows construction of the ZC sequences, and hence the RF signal, with constant amplitude. While maintaining constant amplitude the interpolated ZC sequence present no and/or insignificant reduction in autocorrelation characteristics compared to similar ZC sequences which are not interpolated and are thus highly suitable for deriving the LTE signal, for example, the RACH signal.

Interpolating the ZC sequences in the phase domain may allow overcoming inherent disadvantages of the ZC sequences, for example, high peak-to-average ratio and/or high speed phase modulation. The interpolated ZC sequences maintain constant amplitude and employ no amplitude modulation which may reduce the spectrum splatter induced by the amplitude modulation when passed through a non-linear power amplifier. The reduced modulation bandwidth may also serve to avoid further filtering of a constant amplitude RF signal (pulse shaping) derived from the interpolated ZC sequences thus preventing the loss of the constant amplitude property which could result from such filtering. Moreover, the constant amplitude of the RF signal may allow using low-end power amplifiers for transmitting the RF signal since the power amplifiers may operate at full power at the saturation region. Operation at the saturation region may significantly increase efficiency and/or reduce power consumption of the amplifiers as well as increase battery life for battery operated UEs integrating the amplifiers. Furthermore, simple, efficient and/or low-power transmitter architectures, for example, a polar transmitter architecture may be used for transmitting the RF signals.

The improved efficiency of the UEs' amplifier may increase transmission performance, for example, in extreme coverage conditions. Current solutions for extreme coverage conditions such as, for example, tone-hopping introduce complexity and/or degraded performance to one or more elements of the LTE infrastructure and/or protocol such as, for example, employing different protocols for different coverage conditions and/or degraded TOA estimation. The interpolated ZC sequences approach may significantly reduce the LTE protocol complexity as only a single protocol may be used for various coverage conditions while not degrading the timing estimation accuracy, for example the TOA estimation characteristics of the LTE signals, for example, the RACH signals.

The interpolation process of the ZC sequences from which an RF signal is derived starts with identifying phase differences between every two consecutive samples of the ZC sequence(s). The phase differences may be wrapped, i.e. the absolute phase difference value is larger than pi. Un-wrapping refers to bringing the absolute value of the wrapped phase difference into a primary region (which is no larger than pi) prior to interpolating the phase differences. Un-wrapping is done by changing the phase difference value to its 2*pi complement. The phase differences are then interpolated, i.e. up-sampled and submitted (convoluted) to a filter, for example a low-pass filter such as, for example, a Gaussian filter convolved with a rectangular pulse forming a 'modified Gaussian filter' in order to limit the phase modulation spectrum which may result in reduced out-of-band emissions. The interpolated phase difference samples are then converted to Cartesian coordinates and manipulated to adjust the sampling rate of the resulting sequence so it may be converted to a time domain to create a time domain RF signal. The RF signal (in the time domain) may optionally be submitted to additional wideband filter(s) to meet the RF signal spectrum however the use of additional low pass filter(s) for removing high frequency components from the RF signal is unnecessary and may be avoided.

The filter used for the interpolation may include a plurality of coefficients which may be used to select a trade-of between a bandwidth of the interpolated ZC sequences and hence the RF signal and the timing estimation accuracy, for example, the TOA estimation accuracy.

The interpolated ZC sequences substantially maintain performance characteristics similar and/or insignificantly different compared to the original ZC sequences (with no interpolation). The performance characteristics may include, for example, compliance with regulatory specifications and/or standards, autocorrelation level, missed detection probability and/or timing estimation accuracy and/or errors. Since each sequence in the interpolated ZC sequence set maintains a high ratio between its largest autocorrelation peak and its next largest autocorrelation peak, as well as a high ratio between its largest autocorrelation peak and the largest peak of cross-correlations with other sequences of the set, the interpolated ZC sequences support orthogonality among the RF signals sharing a frequency band. The interpolated ZC sequences may therefore be suitable for deriving the constant amplitude RF signal, in particular the LTE signal and more specifically, the RACH signal so that low-end power amplifiers may be used by the UEs for transmitting the cellular signals while maintaining compliance with regulatory specifications and/or standards, for example, a GSM mask.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

The present invention may be a system, a method, and/or a computer program product. The computer program product may include a computer readable storage medium (or media) having computer readable program instructions thereon for causing a processor to carry out aspects of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing.

Computer readable program instructions described herein can be downloaded to respective computing/processing devices from a computer readable storage medium or to an external computer or external storage device via a network, for example, the Internet, a local area network, a wide area network and/or a wireless network.

The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present invention.

Aspects of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

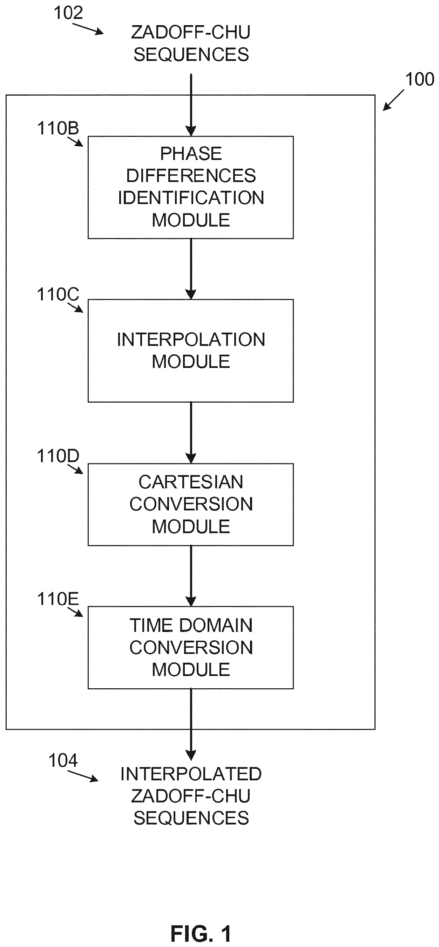

Reference is now made to FIG. 1 which is a schematic illustration of an exemplary apparatus for reducing out-of-band emissions for an RF signal, according to some embodiments of the present invention. An exemplary apparatus 100 includes phase difference identification module 110A which receives one or more ZC sequence(s) 102, an interpolation module 110B, a Cartesian conversion module 110C and a time domain conversion module 110D which drives out one or more interpolated ZC sequence(s) 104. Wherein a module in the context of the present invention be utilized in the form of an electric circuit, a software module and/or a combination of an electric circuit with a software module. Wherein a software module may consist a plurality of program instructions stored in a non-transitory medium and executed by one or more processors and/or one or more cores of one or more processors.

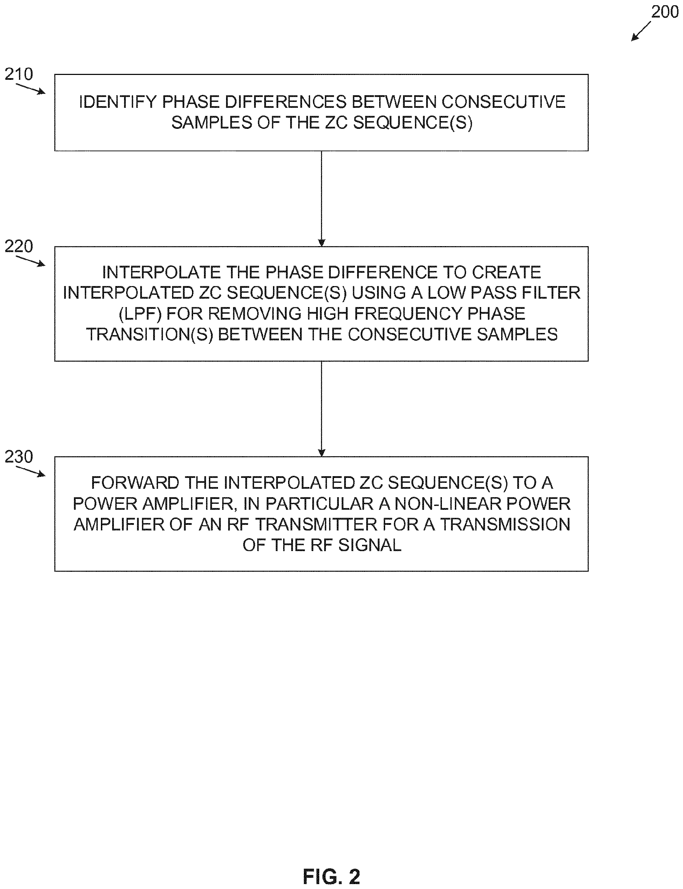

Reference is now made to FIG. 2 which is a flowchart of an exemplary process of reducing out-of-band emissions for an RF signal, according to some embodiments of the present invention. A process 200 for reducing out-of-band emissions for an RF signal may be executed by an apparatus such as the apparatus 100.

As shown at 210, one or more ZC sequences 102 are received by the apparatus 100. An RF signal such as the RF signal 104, in particular an LTE signal, for example, a RACH signal is derived from the ZC sequence(s) 102 meaning the ZC sequence(s) 102 represent the data modulated over the RF signal. Phase differences are identified between every two consecutive samples of the ZC sequence(s) 102 by a module such as the phase identification module 110A. The phase differences may include one or more high frequency components, i.e. fast and/or rapid phase transitions. One or more of the phase differences is a wrapped phase difference meaning its absolute phase value exceeds pi (larger than pi). The wrapped phase differences need to be un-wrapped prior to interpolation and so the phase identification module 110A un-wraps the wrapped phase differences by replacing the phase value of each of the wrapped phase differences to its 2*pi complement value so that the absolute phase values of all the phase differences are within a primary phase region.

As shown at 220, the phase differences are interpolated by a module such as the interpolation module 110C. The phase differences may include one or more high frequency components, i.e. fast and/or rapid phase transitions. The interpolation module 110C up-samples the phase differences to expand the scope of the interpolated ZC sequence(s) 102 and submits the up-sampled sequence to a filter (convolution) to limit the phase modulation bandwidth (spectrum) of the ZC sequence(s) 102. The filter may employ, for example, a linear filter such as, for example a Gaussian filter convolved with a rectangular pulse forming a modified Gaussian filter.

The filter may be applied with one or more weight and/or coefficients which may be used to select the level of limitation of the phase modulation bandwidth which is a trade-off with respect to timing estimation accuracy, for example a time of arrival (TOA) estimation accuracy. Following the interpolation, the filtered phase differences may be converted to Cartesian coordinates by a module such as the Cartesian conversion module 110D.

One or more samples may be removed and/or added to adjust a sample count of the phase differences to fit further conversions. The converted phase differences are then converted to the time domain by a module such as the time domain conversion module 110E.

Optionally, the interpolated ZC sequence(s) 104 are forced to have a constant envelope.

As shown at 230, the apparatus 100 may forward the interpolated ZC sequence(s) 104 to be used to derive the RF signal, in particular an LTE signal, for example, a RACH signal. The RF signal may be transmitted out through an RF transmitter.

Since the phase modulation spectrum is limited by the apparatus 100 executing the process 200, further filtering (pulse shaping) in the time domain may not be required.

Since the interpolated ZC sequences 104 maintain constant amplitude the derived RF signal also maintains constant amplitude. As the derived constant amplitude RF signal is not subjected to amplitude modulation the RF signal may not suffer spectrum splatter effects induced by the amplitude modulation. The constant amplitude of the RF signal allows transmission using efficient low-end amplifiers operating at their saturation region with no and/or insignificant distortions resulting from the amplifiers non-linearity. Due to the constant amplitude of the RF signal even when transmitted with the low-end amplifiers operating at the saturation region the RF signal may be fully compliant with regulatory specifications and/or standards, for example, a GSM mask.

The interpolated ZC sequence(s) 104 substantially maintain autocorrelation characteristics of the original ZC sequences 102 thus support orthogonality among the RF signals which may share a common frequency band. The interpolated ZC sequences may therefore be suitable for deriving the constant amplitude RF signal, in particular the LTE signal, for example, the RACH signal so that multiple UEs may share a common frequency band for communicating with one or more receivers, for example, a base-station.

Some embodiments of the present disclosure are provided through examples with reference to the accompanying drawings. However, this invention may be embodied in many different forms and should not be construed as limited to any specific structure or function presented herein.

By way of example, and not limitation, a RACH preamble signal derived from a 251 samples ZC sequence is presented herein.

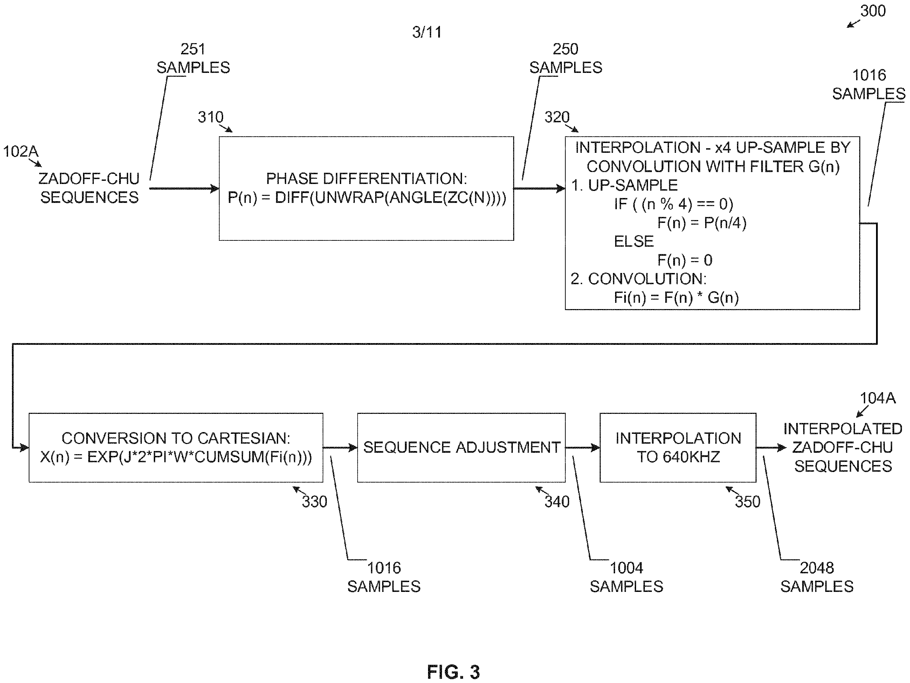

Reference is now made to FIG. 3 which is a schematic illustration of an exemplary apparatus implementation for reducing out-of-band emissions for a RACH preamble signal, according to some embodiments of the present invention. An apparatus 300 includes a phase differentiation module 310 which receives one or more 251-samples ZC sequence(s) 102A, an interpolation module 320, a Cartesian conversion module 330, a sequence adjustment module 340 and an output interpolation module 350 which drives out one or more interpolated ZC sequence(s) 104A. The ZC sequences 102A have a bandwidth of 80KHz and are used to derive a RACH signal sampled at 640KHz. The phase differentiation module 310 identifies phase differences between every two consecutive samples of the ZC sequence(s) 102A. The phase differences may include one or more high frequency components, i.e. fast and/or rapid phase transitions. The phase differentiation module 310 un-wraps one or more wrapped phase difference in order to bring an absolute phase value of each of the phase differences into a primary phase region. The absolute phase value of the wrapped phase differences exceeds pi (is larger than pi). The phase differentiation module 310 un-wraps the wrapped phase differences by replacing the phase value of each of the wrapped phase differences with its 2*pi complement. The phase differentiation module 310 outputs 250 samples which are the phase differences between the 251 samples of the ZC sequence 102A. The phase differences are then interpolated in the interpolation module 320 by up-sampling by a factor of 4 and submitted to a filter such as a modified Gaussian filter (convolution). The up-sampling by a factor of 4 results in 1016 phase difference samples. One or more properties of the modified Gaussian filter, for example, spectrum edge frequencies may be adjusted through one or more weight and/or coefficients applied to the phase differences during the convolution. The coefficients may determine, for example, the trade-off between the phase modulation bandwidth and the timing estimation accuracy.

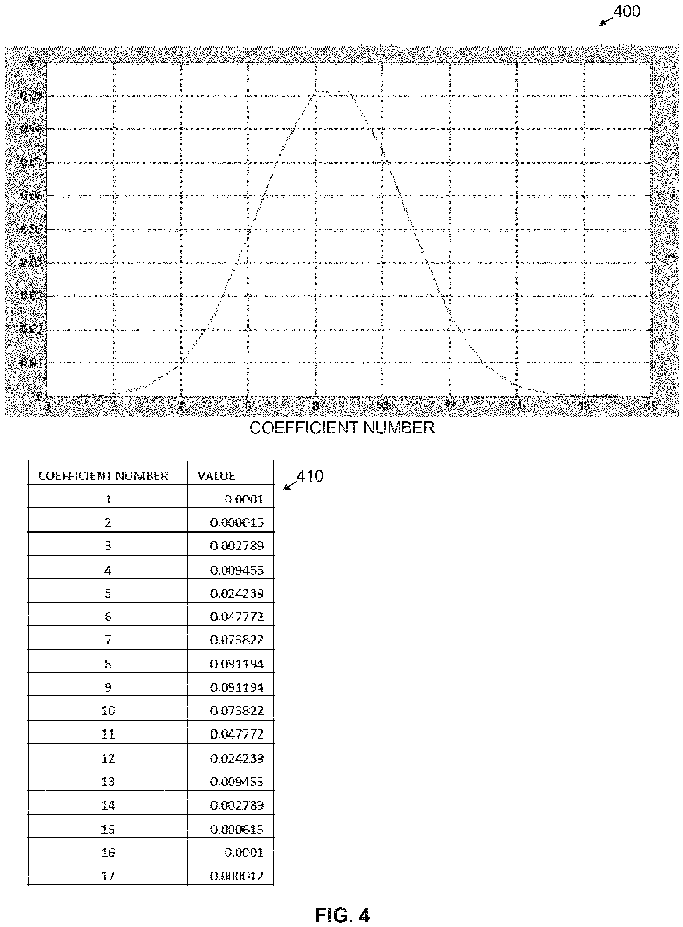

Reference is now made to FIG. 4 which is a schematic illustration of an exemplary modified Gaussian filter used for interpolating ZC sequences, according to some embodiments of the present invention. A graph of an exemplary modified Gaussian filter 400 which may be applied to ZC sequence(s) such as the ZC sequence(s) 102A is presented. The modified Gaussian filet 400 is formed by convolving a Gaussian filter with a rectangular shaped pulse. A table 410 presents a list of coefficients which may be used to expand and/or shrink the filter's bandwidth. The filter's bandwidth may in turn affect one or more characteristics of an interpolated ZC sequence(s) such as the interpolated ZC sequence(s) 104A. The coefficients may be BT coefficients where B is the 3 dB bandwidth of the original Gaussian filter (not convolved) with an impulse response, and T is the duration of one input data bit.

Reference is now made once again to FIG. 3. Following the interpolation, the interpolated phase differences may be applied to the Cartesian conversion module 330 which may convert the phase differences to Cartesian coordinates. The converted phase differences may be further manipulated by the sequence adjustment module 340 which removes the leading 4 samples and the last 8 samples to produce a 1004 samples sequence. The output interpolation module 350 interpolates the phase differences at 640KHz and converts them to the time domain producing a 2048 samples interpolated ZC sequence(s) 104A having a duration of 3.2us.

To achieve optimal phase bandwidth limits for the interpolated ZC sequence(s) 104A a BT coefficient of 0.3 may be selected for the modified Gaussian filter 400 and a value of 0.32 may be selected for the coefficient W of the output interpolation module 330.

The interpolated ZC sequence(s) 104A may be forced to a constant envelope after being driven out of the output interpolation module 350 and before they are forwarded to an RF transmitter.

The constant amplitude interpolated ZC sequence(s) 104A may serve to derive RACH signals for a wide coverage range extending to extreme coverage conditions with worst case mean coupling loss (MCL) of 164dB.

The interpolated ZC sequence(s) 104A may be used to derive a constant amplitude RACH signal which maintains performance characteristics similar and/or insignificantly lower compared to the original ZC sequence(s) 102 which have not undergone the interpolation process by an apparatus such as the apparatus 300. The performance characteristics may include, for example, compliance with regulatory specifications and/or standards, autocorrelation level, missed detection probability and/or timing estimation accuracy and/or errors.

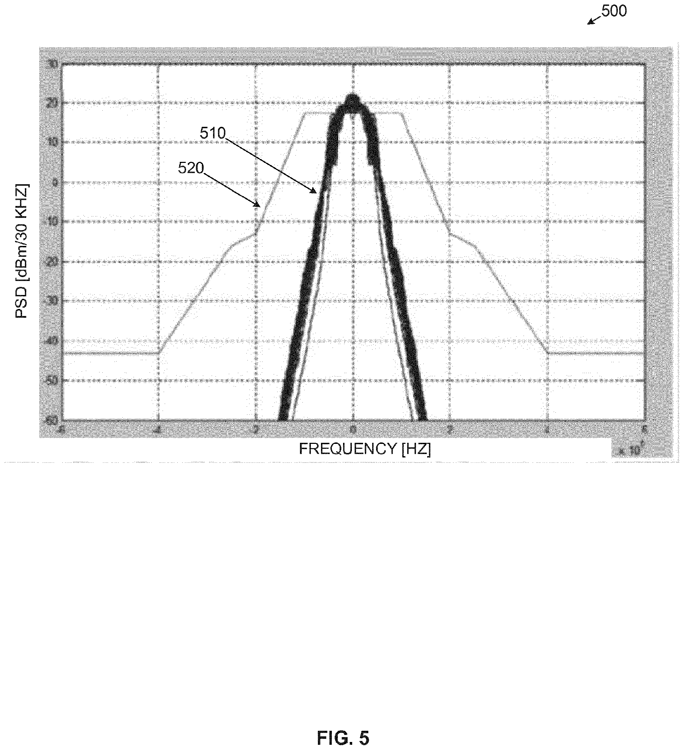

Reference is now made to FIG. 5 which is a schematic illustration of a spectral view presenting an exemplary set of interpolated ZC sequences with respect to a GSM spectral mask, according to some embodiment of the present invention. A graph 510 presents the spectral distribution of 250 interpolated ZC sequences such as the interpolated ZC sequences 102A. As evident from the graph 510 most energy of the interpolated ZC sequences 102A is concentrated the center of the spectrum of the interpolated ZC sequences 102A with the spectrum edges (or skirts, or side-lobs) rolling off rapidly. The spectrum of the interpolated ZC sequences 102A is fully compliant with a GSM spectral mask 520. As the spectrum of the interpolated ZC sequences 102A is so narrowly centered at the center of the RACH signal spectrum no further filtering may be required at the output of the apparatus 300 to comply with the a GSM spectral mask 520.

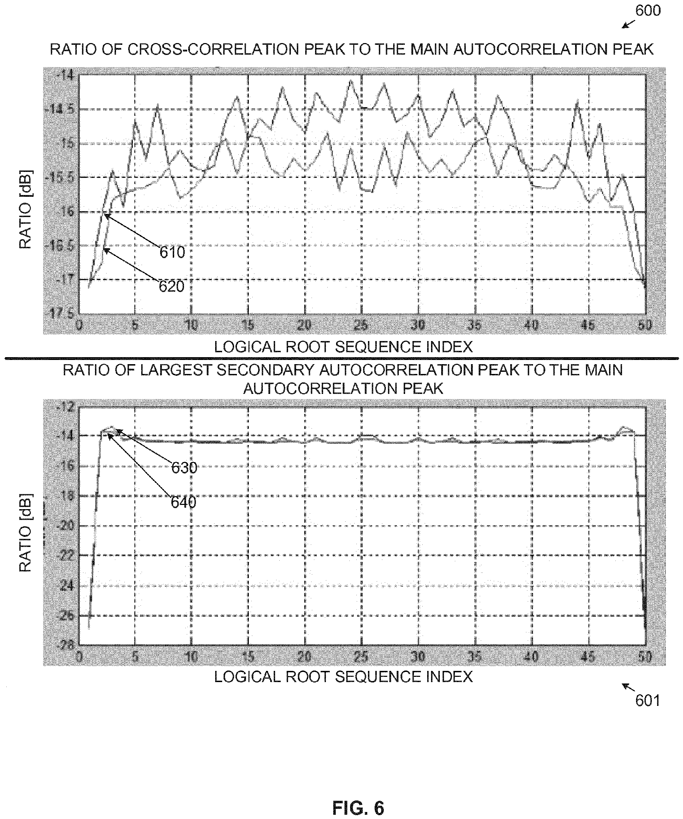

Reference is now made to FIG. 6 which is a schematic illustration of correlation characteristics graphs of exemplary ZC sequences and interpolated ZC sequences, according to some embodiment of the present invention. A graph capture 600 presents a ratio graph 610 of a cross-correlation peak to a main autocorrelation peak for interpolated ZC sequences such as the interpolated ZC sequences 104A compared to a ratio graph 620 of the cross-correlation peak to the main autocorrelation peak for original (non-interpolated) ZC sequences such as the interpolated ZC sequences 102A. Both the interpolated ZC sequences 104A and original ZC sequences 102A are shifted at 50Hz. As seen in the graph capture 600 the cross-correlation ratio graph 620 is substantially similar to the cross-correlation ratio graph 610. There is a slight degradation in the cross-correlation ratio for the ratio graph 620 but it is negligible and does not degrade the orthogonality of the interpolated ZC sequences 104A.

A graph capture 601 presents a ratio graph 630 of a largest secondary autocorrelation peak to the main autocorrelation peak for the interpolated ZC sequences 104A compared to a ratio graph 640 of the largest secondary autocorrelation peak to the main autocorrelation peak for original ZC sequences 102A. Both the interpolated ZC sequences 104A and original ZC sequences 102A are shifted at 50Hz. As seen in the graph capture 601 the autocorrelation ratio graph 630 is substantially similar to the autocorrelation ratio graph 640.

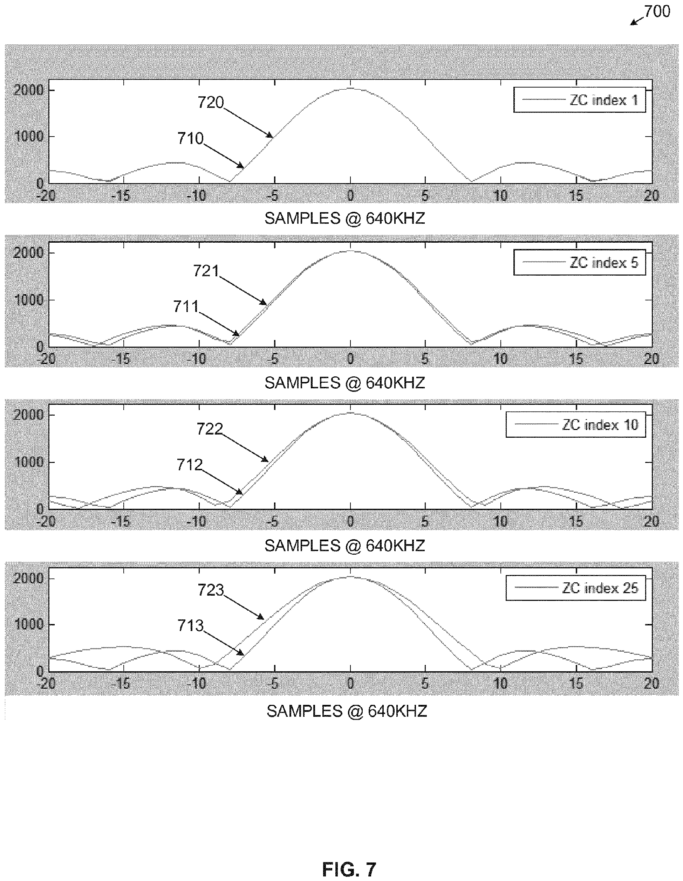

Reference is now made to FIG. 7 which is a schematic illustration of an autocorrelation peak graph for exemplary ZC sequences and interpolated ZC sequences, according to some embodiment of the present invention. A capture 700 presents a comparison between the autocorrelation peak of exemplary ZC sequences such as the ZC sequences 102A and interpolated ZC sequences such as the interpolated ZC sequences 104A. The graphs 710 and 720 present the autocorrelation peak for the interpolated ZC sequences 104A sequence index 1 and the original ZC sequences 102A sequence index 1 respectively. The graphs 711 and 721 present the autocorrelation peak for the interpolated ZC sequences 104A sequence index 5 and the original ZC sequences 102A sequence index 5 respectively. The graphs 712 and 722 present the autocorrelation peak for the interpolated ZC sequences 104A sequence index 10 and the original ZC sequences 102A sequence index 10 respectively. The graphs 713 and 723 present the autocorrelation peak for the interpolated ZC sequences 104A sequence index 25 and the original ZC sequences 102A sequence index 25 respectively. As evident from the capture 700 the autocorrelation characteristics are substantially similar for the interpolated ZC sequences 104A compared to the original ZC sequences 102A. The autocorrelation peak is identical for the index 1 sequence of the interpolated ZC sequences 104A and the original ZC sequences 102A and it gradually degrades for higher index sequences. The degradation however is minor and may not impact the autocorrelation characteristics of the interpolated ZC sequences 104A compared to the original ZC sequences 102A.

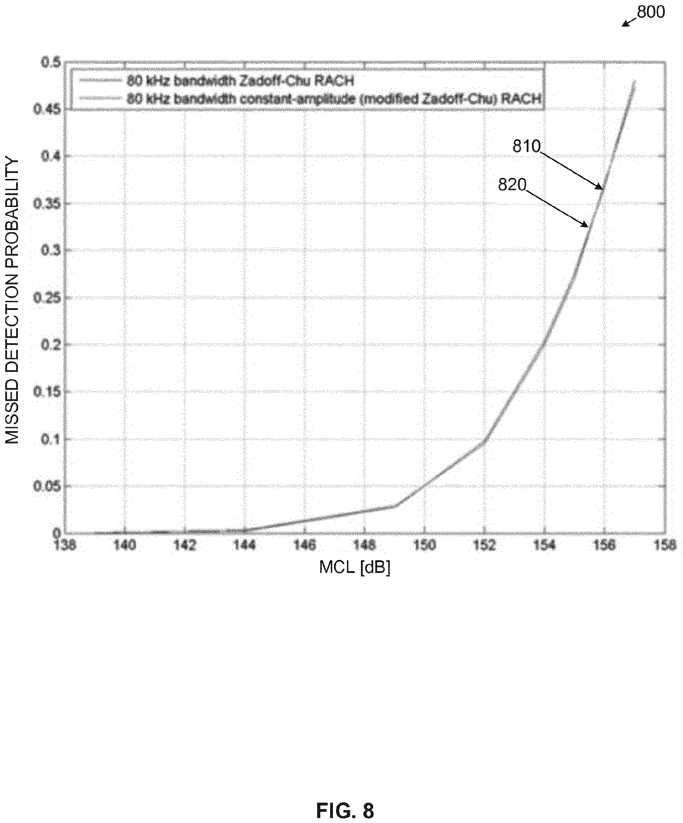

Reference is now made to FIG. 8 which is a schematic illustration of missed detection probability graph of an exemplary interpolated RACH preamble signal and an exemplary original RACH preamble signal, according to some embodiment of the present invention. A capture 800 presents a comparison between the missed detection probability of exemplary ZC sequences such as the ZC sequences 102A and interpolated ZC sequences such as the interpolated ZC sequences 104A. As evident from the capture 800, a missed detection probability graph 810 associated with the interpolated ZC sequences 104A is substantially similar to a missed detection probability graph 820 associated with the interpolated ZC sequences 102A.

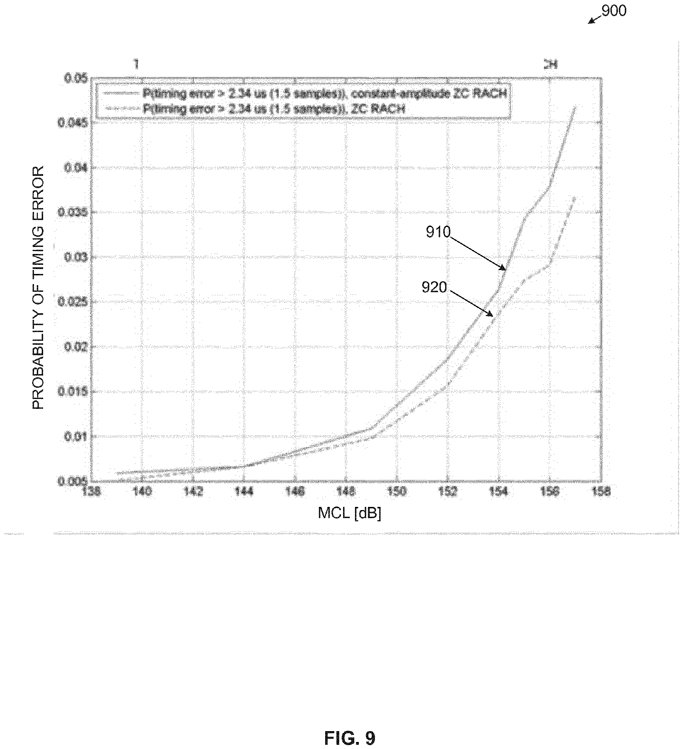

FIG. 9 is a schematic illustration of timing estimation error probability graph of exemplary interpolated RACH preamble signal and an exemplary original RACH preamble signal, according to some embodiment of the present invention. A capture 900 presents a comparison between the timing error probability of exemplary ZC sequences such as the ZC sequences 102A and interpolated ZC sequences such as the interpolated ZC sequences 104A. As evident from the capture 900, at an MCL of 144 dB, a timing error probability of the interpolated ZC sequences 104A as presented by graph 910 is substantially similar to the timing error probability of the original ZC sequences 102A as presented by graph 920.

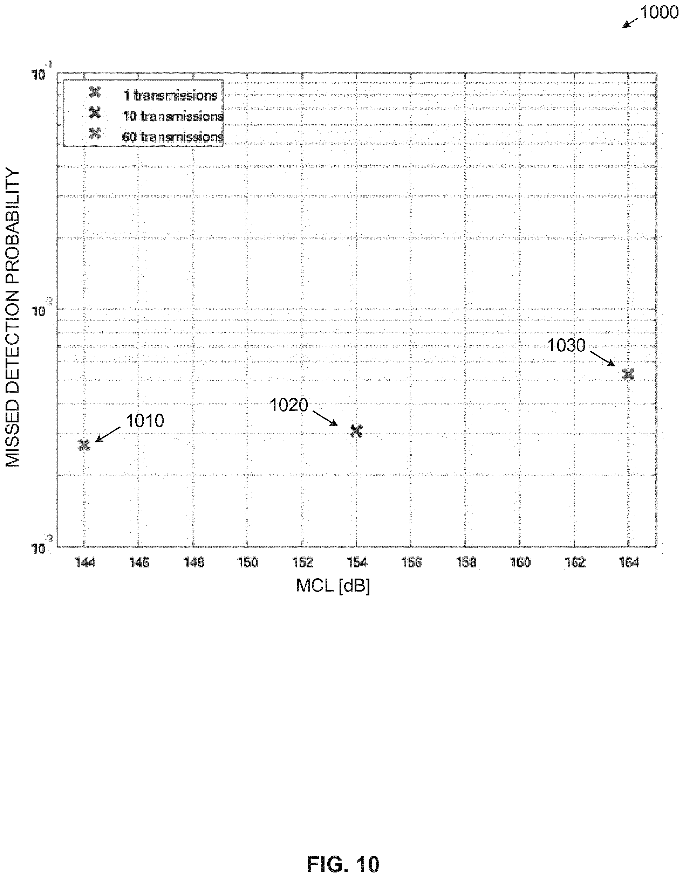

FIG. 10 is a schematic illustration of missed detection probability graph of an exemplary interpolated RACH preamble signal with repetitions, according to some embodiment of the present invention. A capture 1000 presents missed detection probability values for a RACH preamble signal derived from interpolated ZC sequences such as the interpolated ZC sequences 104A. A value 1010 presents the missed detection probability value for the RACH preamble signal with MCL of 144dB. A value 1020 presents the missed detection probability value for the RACH preamble signal with MCL of 154dB. A value 1030 presents the missed detection probability value for the RACH preamble signal with MCL of 164dB. The RACH preamble signal is repeated (re-transmitted) 60 times. As seen in the capture 1000, the value of the missed detection probability slightly increases when moving towards extreme coverage conditions - 164dB, however the degradation is minor and the RACH preamble signal may fully comply with the regulation specifications and/or standards.

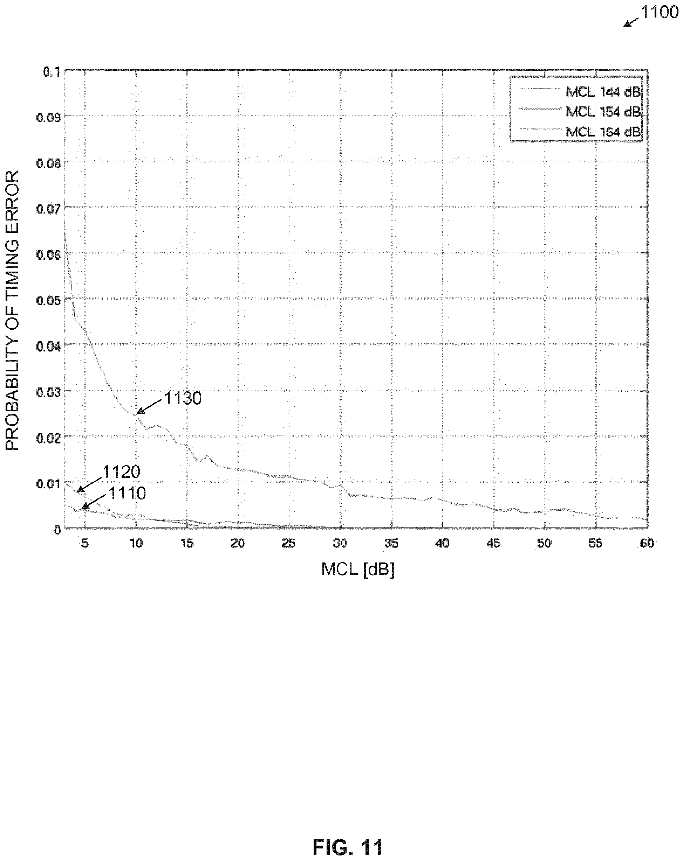

FIG. 11 is a schematic illustration of timing error probability graph of an exemplary interpolated RACH preamble signal with repetitions, according to some embodiment of the present invention. A capture 1100 presents timing error probability graph for a RACH preamble signal derived from interpolated ZC sequences such as the interpolated ZC sequences 104A with respect to a number of repetitions (re-transmissions) for various coverage conditions. A graph 1110 presents the timing error probability for the RACH preamble signal with MCL of 144dB. A graph 1120 presents the timing error probability for the RACH preamble signal with MCL of 154dB. A graph 1130 presents the timing error probability for the RACH preamble signal with MCL of 164dB. As seen in the capture 1100, for all coverage conditions the timing error probability decreases as the number of repetitions is increased. The graph 1130 presenting the timing error probability for extreme coverage is considerably higher than the timing error probability of the less harsh coverage conditions as presented in the graphs 1110 and 1120. However even the timing error probability in extreme coverage conditions as presented by the graph 1130 may fully comply with the regulation specifications and/or standards thus avoiding the need to use different protocols for different coverage conditions and specifically for extreme coverage conditions.

The descriptions of the various embodiments of the present invention have been presented for purposes of illustration, but are not intended to be exhaustive or limited to the embodiments disclosed. The terminology used herein was chosen to best explain the principles of the embodiments, the practical application or technical improvement over technologies found in the marketplace, or to enable others of ordinary skill in the art to understand the embodiments disclosed herein.

It is expected that during the life of a patent maturing from this application many relevant RF signals employing ZC sequences will be developed.

As used herein the term "about" refers to ± 10 %.

The terms "comprises", "comprising", "includes", "including", "having" and their conjugates mean "including but not limited to". This term encompasses the terms "consisting of" and "consisting essentially of".

The phrase "consisting essentially of" means that the composition or method may include additional ingredients and/or steps, but only if the additional ingredients and/or steps do not materially alter the basic and novel characteristics of the claimed composition or method.

As used herein, the singular form "a", "an" and "the" include plural references unless the context clearly dictates otherwise. For example, the term "a compound" or "at least one compound" may include a plurality of compounds, including mixtures thereof.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment of the invention may include a plurality of "optional" features unless such features conflict.

Throughout this application, various embodiments of this invention may be presented in a range format. It should be understood that the description in range format is merely for convenience and brevity and should not be construed as an inflexible limitation on the scope of the invention. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals there between.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable subcombination or as suitable in any other described embodiment of the invention. Certain features described in the context of various embodiments are not to be considered essential features of those embodiments, unless the embodiment is inoperative without those elements.

## Claims

1. An apparatus (100) for reducing out-of-band emissions of a radio frequency, RF, signal, wherein the apparatus comprises a low pass filter, LPF, and an RF transmitter comprising a non-linear power amplifier and wherein:
the apparatus is configured to identify phase differences between at least two consecutive samples of a Zadoff-Chu, ZC, sequence (102) from which an RF signal is derived;
the apparatus is configured to perform an un-wrapping procedure in which, for each phase difference which is a wrapped phase difference having an absolute value which is larger than pi, the wrapped phase difference is un-wrapped by replacing it with its 2*pi complement;
the LPF is configured to interpolate the un-wrapped phase differences to create an interpolated ZC phase difference sequence (104), for reducing at least one phase difference between consecutive samples;
the apparatus is further configured to convert the interpolated ZC phase difference sequence to an interpolated ZC sequence in a time domain; and
the apparatus is configured to forward the interpolated ZC sequence to the non-linear power amplifier, for a transmission of the RF signal.

2. The apparatus of claim 1, wherein the RF transmitter is configured to transmit the interpolated ZC sequence (104) in the RF signal as a random access channel, RACH, sequence.

3. The apparatus of claim 1, wherein the LPF comprises a modified Gaussian filter (400) formed by convolving a Gaussian filter with a rectangular pulse.

4. A method (200) for reducing out-of-band emissions of a radio frequency, RF, signal, comprising:
identifying phase differences between at least two consecutive samples of at least one Zadoff-Chu, ZC, sequence (102) from which an RF signal is derived (210);
for each identified phase difference which is a wrapped phase difference having an absolute value which is larger than pi, un-wrapping the wrapped phase difference by replacing it with its 2*pi complement
interpolating the un-wrapped phase differences to create an interpolated ZC phase difference sequence (104) using a low pass filter, LPF, for reducing at least one phase difference between the consecutive samples (220);
converting the interpolated ZC phase difference sequence to an interpolated ZC sequence in a time domain; and
forwarding the interpolated ZC sequence to a non-linear power amplifier of an RF transmitter, for a transmission of the RF signal (230).

5. The method of claim 4, wherein the at least one interpolated ZC sequence (104) is transmitted in the RF signal as at least one random access channel, RACH, sequence.

## Patentansprüche

1. Vorrichtung (100) zum Reduzieren von Out-of-Band-Emissionen eines Hochfrequenz (HF)-Signals, wobei die Vorrichtung einen Tiefpassfilter (LPF - Low Pass Filter) und einen HF-Sender umfasst, der einen nichtlinearen Leistungsverstärker umfasst, und wobei:
die Vorrichtung dazu konfiguriert ist, Phasendifferenzen zwischen mindestens zwei aufeinanderfolgenden Abtastwerten einer Zadoff-Chu (ZC)-Sequenz (102) zu identifizieren, aus der ein HF-Signal abgeleitet wird;
die Vorrichtung dazu konfiguriert ist, ein Abwicklungsverfahren durchzuführen, bei dem für jede Phasendifferenz, bei der es sich um eine gepackte Phasendifferenz mit einem Absolutwert handelt, der größer als Pi ist, die gepackte Phasendifferenz entpackt wird, indem sie durch ihre 2*Pi-Ergänzung ersetzt wird;
der LPF dazu konfiguriert ist, die entpackte Phasendifferenzen zu interpolieren, um eine interpolierte ZC-Phasendifferenzsequenz (104) zu erzeugen und so mindestens eine Phasendifferenz zwischen aufeinanderfolgenden Abtastwerten zu verringern;
die Vorrichtung ferner dazu konfiguriert ist, die interpolierte ZC-Phasendifferenzsequenz in eine interpolierte ZC-Sequenz in einem Zeitbereich umzuwandeln; und
die Vorrichtung dazu konfiguriert ist, die interpolierte ZC-Sequenz zur Übertragung des HF-Signals an den nichtlinearen Leistungsverstärker weiterzuleiten.

2. Vorrichtung nach Anspruch 1, wobei der HF-Sender dazu konfiguriert ist, dass er die interpolierte ZC-Sequenz (104) in dem HF-Signal als Direktzugriffs (RACH - Random Access Channel)-Sequenz sendet.

3. Vorrichtung nach Anspruch 1, wobei der LPF einen modifizierten Gaußschen-Filter (400) umfasst, der durch Faltung eines Gaußschen-Filters mit einem Rechteckimpuls gebildet wird.

4. Verfahren (200) zum Reduzieren von Out-of-Band-Emissionen eines Hochfrequenzsignals, umfassend:
Identifizieren von Phasendifferenzen zwischen mindestens zwei aufeinanderfolgenden Abtastwerten mindestens einer Zadoff-Chu (ZC)-Sequenz (102), aus der ein HF-Signal abgeleitet wird (210);
bei jeder identifizierten Phasendifferenz, bei der es sich um eine gepackte Phasendifferenz mit einem Absolutwert handelt, der größer als Pi ist, Entpacken der gepackten Phasendifferenz, indem sie durch ihre 2*Pi-Ergänzung ersetzt wird;
Interpolieren der entpackten Phasendifferenzen, um eine interpolierte ZC-Phasendifferenzsequenz (104) mit einem Tiefpassfilter (LPF) zu erzeugen und so mindestens eine Phasendifferenz zwischen den aufeinanderfolgenden Abtastwerten (220) zu verringern;
Umwandeln der interpolierten ZC-Phasendifferenzsequenz in eine interpolierte ZC-Sequenz in einem Zeitbereich; und
Weiterleiten der interpolierten ZC-Sequenz an einen nichtlinearen Leistungsverstärker eines HF-Senders zur Übertragung des HF-Signals (230).

5. Verfahren nach Anspruch 4, wobei die mindestens eine interpolierte ZC-Sequenz (104) im HF-Signal als mindestens eine Direktzugriffs (RACH)-Sequenz übertragen wird.

## Revendications

1. Appareil (100) de réduction d'émissions hors bande d'un signal radiofréquence, RF, dans lequel l'appareil comprend un filtre passe-bas, LPF, et un transmetteur RF comprenant un amplificateur de puissance non linéaire et dans lequel :
l'appareil est configuré pour identifier des différences de phase entre au moins deux échantillons consécutifs d'une séquence Zadoff-Chu, ZC (102) à partir de laquelle un signal RF est dérivé ;
l'appareil est configuré pour effectuer une procédure de déballage dans laquelle, pour chaque différence de phase qui est une différence de phase enveloppée présentant une valeur absolue qui est supérieure à pi, la différence de phase enveloppée est déballée en la remplaçant par son complément 2*pi ;
le LPF est configuré pour interpoler les différences de phase non enveloppées afin de créer une séquence de différence de phase ZC interpolée (104), pour réduire au moins une différence de phase entre des échantillons consécutifs ;
l'appareil est en outre configuré pour convertir la séquence de différence de phase ZC interpolée en une séquence ZC interpolée dans un domaine temporel ; et
l'appareil est configuré pour transmettre la séquence ZC interpolée à l'amplificateur de puissance non linéaire, pour une transmission du signal RF.

2. Appareil selon la revendication 1, dans lequel le transmetteur RF est configuré pour transmettre la séquence ZC interpolée (104) dans le signal RF sous la forme d'une séquence de canal d'accès aléatoire, RACH.

3. Appareil selon la revendication 1, dans lequel le LPF comprend un filtre gaussien modifié (400) formé par convolution d'un filtre gaussien avec une impulsion rectangulaire.

4. Procédé (200) de réduction d'émissions hors bande d'un signal radiofréquence, RF, comprenant :
l'identification de différences de phase entre au moins deux échantillons consécutifs d'au moins une séquence Zadoff-Chu, ZC (102) à partir de laquelle un signal RF est dérivé (210) ;
pour chaque différence de phase identifiée qui est une différence de phase enveloppée présentant une valeur absolue qui est supérieure à pi, le déballage de la différence de phase enveloppée en la remplaçant par son complément 2*pi
l'interpolation des différences de phase non enveloppées pour créer une séquence de différence de phase ZC interpolée (104) à l'aide d'un filtre passe-bas, LPF, pour réduire au moins une différence de phase entre les échantillons consécutifs (220) ;
la conversion de la séquence de différence de phase ZC interpolée en une séquence ZC interpolée dans un domaine temporel ; et
la transmission de la séquence ZC interpolée à un amplificateur de puissance non linéaire d'un transmetteur RF, pour une transmission du signal RF (230).

5. Procédé selon la revendication 4, dans lequel l'au moins une séquence ZC interpolée (104) est transmise dans le signal RF sous la forme d'au moins une séquence de canal d'accès aléatoire, RACH.
